# EUROPÄISCHE PATENTSCHRIFT

(11) **EP 2 480 426 B1**
(45) Veröffentlichungstag und Bekanntmachung des Hinweises auf die Patenterteilung: **25.06.2014**
(21) Anmeldenummer: 10742803.9
(22) Anmeldetag: 03.08.2010
(51) Int. Cl.: B60L 3/00, B60L 3/04, B60L 9/00, B60L 11/18, B60L 7/14

(54) **WECHSELRICHTER FÜR EINE ELEKTRISCHE MASCHINE UND VERFAHREN ZUM BETREIBEN EINES WECHSELRICHTERS FÜR EINE ELEKTRISCHE MASCHINE**
INVERTER FOR AN ELECTRIC MACHINE AND METHOD FOR OPERATING AN INVERTER FOR AN ELECTRIC MACHINE
ONDULEUR POUR UNE MACHINE ÉLECTRIQUE ET PROCÉDÉ POUR FAIRE FONCTIONNER UN ONDULEUR POUR UNE MACHINE ÉLECTRIQUE

(30) Priorität: 24.09.2009 DE 102009044944
(43) Veröffentlichungstag der Anmeldung: 01.08.2012
(73) Patentinhaber: Robert Bosch GmbH, 70442 Stuttgart (DE)
(72) Erfinder: SCHWARZ, Albrecht, 71277 Rutesheim (DE); HEIL, Matthias, 71696 Moeglingen (DE); HAAS, Axel, 71720 Oberstenfeld (DE)
(86) Internationale Anmeldenummer: PCT/EP2010/061273
(87) Internationale Veröffentlichungsnummer: WO 2011/035970

(56) Entgegenhaltungen:
- WO-A2-2007/005629
- DE-A1-102007 060 188
- US-B1- 7 279 862

## Beschreibung

Die Erfindung betrifft einen Wechselrichter für eine elektrische Maschine sowie ein Verfahren zum Betreiben eines Wechselrichters für eine elektrische Maschine.

### Stand der Technik

Elektrische Maschinen mit Wechselrichtern werden zum Beispiel in Hybridfahrzeugen eingesetzt, wo sie wahlweise im Motor- oder Generatorbetrieb betrieben werden. Im Motorbetrieb erzeugt die elektrische Maschine ein zusätzliches Antriebsmoment, welches einen Verbrennungsmotor, zum Beispiel in einer Beschleunigungsphase unterstützt, im Generatorbetrieb erzeugt sie elektrische Energie, die in einem Energiespeicher, wie zum Beispiel einer Batterie oder einem Super-Cap gespeichert wird. Betriebsart und Leistung der elektrischen Maschine werden mittels des Wechselrichters eingestellt.

Da bei Hybridkraftfahrzeugen verhältnismäßig hohe Spannungen bereitgestellt werden müssen, um die elektrische Maschine motorisch zum Antreiben des Kraftfahrzeugs verwenden zu können, sind zum Schutz des elektrischen Netzwerks und der an dem elektrischen Netzwerk angeschlossenen Komponenten stets Maßnahmen vorgesehen, die dauerhafte Beschädigungen verhindern.

So ist es beispielsweise bekannt, den elektrischen Speicher von dem Netzwerk elektrisch zu trennen, wenn eine Fehlfunktion des elektrischen Netzwerks erfasst wird. Befindet sich die elektrische Maschine zu diesem Zeitpunkt im generatorischen Betrieb, so hat dies zur Folge, dass sich die Netzwerkspannung stark erhöht, was zur Zerstörung der Endstufen des Wechselrichters führen kann.

Um das zu verhindern, ist es beispielsweise aus der EP 1 524 761 A1 bekannt, bei Überschreiten einer vorgebbaren Grenzspannung des Wechselrichters den Wechselrichter in einen Kurzschlussbetrieb zu schalten.

Aus der DE 102 21 081 A1 ist ein Wechselrichter für eine elektrische Maschine bekannt, der mehrere Schaltelemente umfasst, die in einer Brückenschaltung angeordnet sind und eine Verbindung zwischen der elektrischen Maschine und einer Batterie herstellen. Die im Low-Side-Zweig des Wechselrichters eingebauten Schaltelemente sind solche, die ohne anliegende Steuerspannung leiten, also sogenannte Normally-On-Schaltelemente. Damit wird sichergestellt, dass bei fehlender Versorgungsspannung und sich drehender elektrischer Maschine die Wicklungen der elektrischen Maschine kurzgeschlossen sind und keine Überspannungen auftreten können.

Ein aus der DE 10 2006 003 254 A1 bekanntes Verfahren zum Abschalten einer elektrischen Maschine mit Pulswechselrichter im Falle einer Störung sieht vor, unerwünschte Nebeneffekte beim Abschalten der elektrischen Maschine dadurch zu minimieren und den regulären Maschinenbetrieb zu maximieren, dass die elektrische Maschine zunächst in einen Freischalt-Betrieb, in dem sämtliche Schalter des Pulswechselrichters geöffnet sind, und nachfolgend in einen Kurzschluss-Modus geschaltet wird, in dem die mit dem hohen Potenzial verbundenen Schalter offen und die mit dem niedrigen Potenzial verbundenen Schalter geschlossen sind.

Aus der DE 10 2007 020 509 A1 ist ein Verfahren zur Fehlerbehandlung bei elektrischen Maschinen eines Hybridantriebs bekannt, bei welchem zunächst erfasst wird, ob mindestens ein Betriebsparameter der elektrischen Maschine über einem zugeordneten Betriebsparameter-Grenzwert liegt. Wird dabei erfasst, dass mindestens ein Betriebsparameter über dem zugeordneten Grenzwert liegt, wird ein Versorgungsanschluss der elektrischen Maschine für ein dem Betriebsparameter zugeordnetes Zeitintervall freigeschaltet und der Versorgungsanschluss nach Ablauf des Zeitintervalls auf Masse kurzgeschlossen.

Die Druckschrift DE 10 2007 060 188 A1 offenbart ein Antriebssystem mit einem Antriebsstromrichter, einer permanent erregten Synchronmaschine und eine Steuereinrichtung, wobei die permanent erregte Synchronmaschine klemmenseitig mittels Verbindungsleitungen mit Ausgängen des Antriebsstromrichters elektrisch leitend verbunden sind, wobei in wenigstens zwei Verbindungs-Leitungen jeweils ein Halbleiterschalter angeordnet sind, die steuerungsseitig jeweils mit einem Steuer-Ausgang der Steuereinrichtung verknüpft sind und wobei die Steuereinrichtung eingangsseitig mit einem Fehlerausgang und ausgangsseitig mit Steuereingängen des Antriebsstromrichters verbunden sind.

Die Druckschrift US 7,279,862 B1 offenbart einen Wechselrichter für eine elektrische Maschine mit einer Steuereinheit zum Steuern der Schalter des Wechselrichters im Fehlerfall.

Die Druckschrift WO 2007/005629 A2 offenbart einen Wechselrichter für eine elektrische Maschine in einem Hybridfahrzeug mit einer Steuereinheit für den Wechselrichter und einem Kommunikationspfad zwischen der Steuereinheit und dem Fahrzeugnetzwerk.

### Offenbarung der Erfindung

Der erfindungsgemäße Wechselrichter für eine elektrische Maschine in einem Hybridfahrzeug weist mindestens eine Endstufeneinheit zur Herstellung einer Verbindung zwischen der elektrischen Maschine und einem Energieversorgungsnetz, eine Steuereinheit zum Steuern der mindestens einen Endstufeneinheit sowie eine von dem Energieversorgungsnetz unabhängige Versorgungseinheit zur Energieversorgung der Endstufeneinheit/en auf. Des Weiteren ist mindestens eine der/den Endstufeneinheit/en zugeordnete Notbetrieb-Steuerung zur Steuerung der Endstufeneinheit/en bei Ausfall oder Fehlfunktion der Steuereinheit und/oder der Versorgungseinheit und mindestens eine der/den Endstufeneinheit/en zugeordnete Notbetrieb-Versorgung zur Erzeugung einer Versorgungsenergie für die Endstufeneinheit/en aus dem Energieversorgungsnetz bei Ausfall oder Fehlfunktion der Steuereinheit und/oder der Versorgungseinheit vorgesehen.

Durch das Vorsehen mindestens einer der/den Endstufeneinheit/en zugeordneten Notbetrieb-Steuerung und mindestens einer der/den Endstufeneinheit/en zugeordneten Notbetrieb-Versorgung ist sichergestellt, dass auch bei einer Fehlfunktion der Steuereinheit und/oder der Versorgungseinheit der Wechselrichter, insbesondere Endstufen des Wechselrichters, in einen sicheren Betriebszustand, zum Beispiel einen Kurzschlussbetrieb, geschaltet werden können, so dass Überspannungen im Energieversorgungsnetz, welche zu einer dauerhaften Schädigung der Endstufen führen können, verhindert werden.

Gemäß einer Ausführungsform des Wechselrichters überwacht die mindestens eine Notbetrieb-Steuerung Betriebsparameter innerhalb des Wechselrichters und diagnostiziert einen Fehlerfall, wenn mindestens einer der Betriebsparameter unterhalb eines vorgegebenen unteren Schwellwertes oder oberhalb eines vorgegebenen Schwellwertes liegt. So kann zum Beispiel überwacht werden, ob die durch die Versorgungseinheit zur Verfügung gestellte Versorgungsspannung unter einen vorgegebenen unteren Schwellwert fällt oder auch einen vorgegebenen oberen Schwellwert überschreitet. Ebenso kann beispielsweise überwacht werden, ob die Steuersignale der Steuereinheit innerhalb eines vorgegebenen Signalpegel-Intervalls liegen.

Die Überwachung von Betriebsparametern und die Diagnose eines Fehlerfalls durch die Notbetrieb-Steuerung stellt eine schaltungstechnisch vorteilhafte Ausführungsform des erfindungsgemäßen Wechselrichters dar. Die Überwachung der Betriebsparameter und/oder die Diagnose eines Fehlerfalls können aber alternativ auch in einer oder mehreren getrennten Schaltungskomponenten realisiert sein.

Gemäß einer weiteren Ausführungsform ist die mindestens eine Notbetrieb-Versorgung ein- und abschaltbar ausgeführt. Dadurch ist es möglich, für den Fall, dass nach einem erkannten Fehlerfall die Betriebsparameter wieder in einen erlaubten Wertebereich zurückkehren, von dem Notbetrieb wieder in den Normalbetrieb umzuschalten.

Gemäß dem erfindungsgemäßen Verfahren zum Betreiben eines Wechselrichters für eine elektrische Maschine in einem Hybridfahrzeug, wobei der Wechselrichters mindestens eine Endstufeneinheit zur Herstellung einer Verbindung zwischen der elektrischen Maschine und einem Energieversorgungsnetz aufweist, wird/werden im Normalbetrieb die Endstufeneinheit/en über eine von dem Energieversorgungsnetz unabhängige Versorgungseinheit mit Energie versorgt und über eine Steuereinheit gesteuert. Im Notbetrieb, welcher bei Ausfall oder Fehlfunktion der Steuereinheit und/oder der Versorgungseinheit aktiviert wird, wird durch mindestens eine Notbetrieb-Versorgung Energie zur Energieversorgung der Endstufeneinheit/en aus dem Energieversorgungsnetz erzeugt und die Endstufeneinheit/en wird/werden durch mindestens eine Notbetrieb-Steuerung gesteuert.

Gemäß einer Ausführungsform des erfindungsgemäßen Verfahrens wird die mindestens eine Notbetrieb-Versorgung nach Diagnose eines Fehlerfalles eingeschaltet und vorteilhaft wieder abgeschaltet, sobald kein Fehlerfall mehr diagnostiziert wird.

Gemäß einer weiteren Ausführungsform kann auch der Stromfluss durch die Endstufen überwacht werden und bei Diagnose eines Überstromes kann das Schalten in einen Kurzschlussbetrieb verhindert werden oder ein bereits begonnener Kurzschlussbetrieb abgebrochen werden. Auf diese Weise kann auch eine Schädigung der Endstufen durch Überströme vermieden werden.

Weitere Merkmale und Vorteile von Ausführungsformen der Erfindung ergeben sich aus der nachfolgenden Beschreibung mit Bezug auf die beigefügten Figuren.

### Kurze Beschreibung der Figuren

Es zeigen:

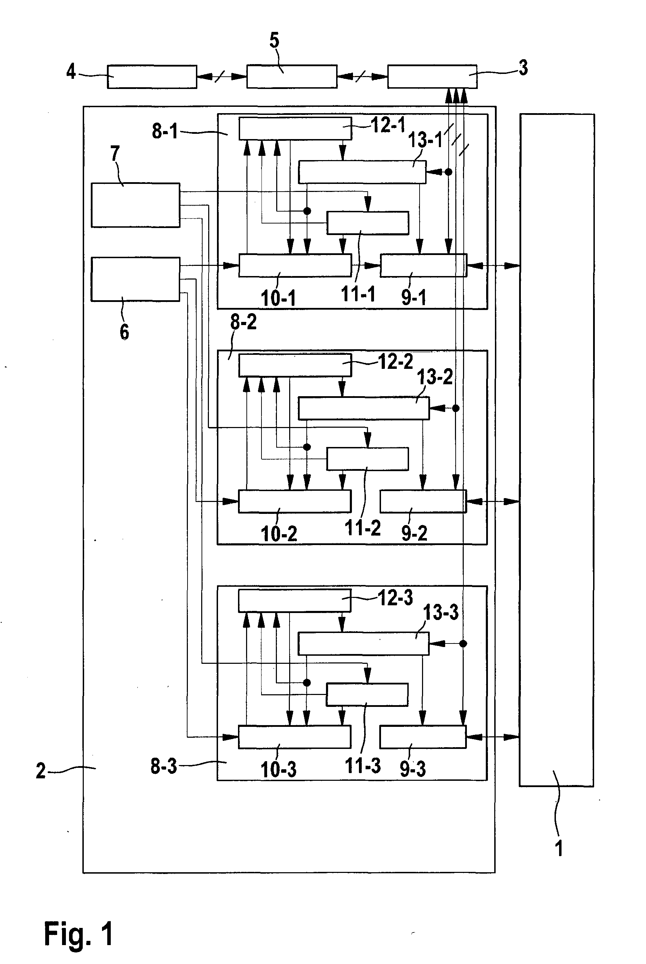

- Fig. 1: ein schematisches Blockschaltbild eines erfindungsgemäßen Wechselrichters, und
- Fig. 2: eine schematische Darstellung einer Schaltungsanordnung zur Durchführung des erfindungsgemäßen Verfahrens.

Eine elektrische Maschine 1 ist über einen Wechselrichter 2 mit einem Energieversorgungsnetz 3, welches zum Beispiel als Hochvolt-Traktionsnetz in einem Hybridfahrzeug ausgeführt sein kann, verbunden. Wird die elektrische Maschine 1 im Motorbetrieb betrieben, so wird sie aus dem Energieversorgungsnetz 3 mit Energie versorgt. Bei Betrieb im Generatorbetrieb kann die elektrische Maschine umgekehrt elektrische Energie in das Energieversorgungsnetz 3 einspeisen. Das Energieversorgungsnetz 3 ist mit einem Energiespeicher 4, zum Beispiel einer Batterie, verbunden. Über einen Schalter 5 ist das Energieversorgungsnetz 3, insbesondere bei Erkennen einer Fehlfunktion innerhalb des elektrischen Netzwerkes, von dem Energiespeicher 4 trennbar. Der Wechselrichter 2 weist eine Steuereinheit 6, eine Versorgungseinheit 7 sowie Endstufeneinheiten 8 auf. Dabei ist für jede Phase der elektrischen Maschine 1 jeweils eine Endstufeneinrichtung 8 vorgesehen. Im dargestellten Beispiel wird von einer dreiphasigen elektrischen Maschine ausgegangen, so dass drei Endstufeneinheiten 8-1, 8-2 und 8-3 vorgesehen sind. Abhängig von der Anzahl der Phasen der elektrischen Maschine 1 können aber auch mehr oder weniger als drei Endstufeneinheiten vorgesehen sein.

Die Versorgungseinheit 7 dient der Energieversorgung der Endstufeneinheiten 8-1, 8-2 und 8-3. Sie ist unabhängig von dem Energieversorgungsnetz 3 ausgeführt und wird beispielsweise über das Niedervolt-Bordnetz eines Hybridfahrzeuges gespeist. Die Steuerung der Endstufeneinheiten 8-1, 8-2 und 8-3 erfolgt über die Steuereinheit 6.

Die Endstufeneinheiten 8 weisen jeweils eine Endstufe 9, zum Beispiel in Form einer Leistungshalbleiterschaltung, und eine Endstufenansteuerung 10 auf. Da die Endstufeneinheiten 8 in der dargestellten Ausführungsform potentialfrei ausgeführt sind, ist in den Endstufeneinheiten 8 jeweils eine Phasen-Versorgungseinheit 11 vorgesehen, welche jeweils zwischen die Versorgungseinrichtung 7 und die Endstufenansteuerung 10 geschaltet ist. Im Normalbetrieb werden die Endstufenansteuerungen 10-1, 10-2 und 10-3 über die Phasen-Versorgungseinheiten 11-1, 11-2 bzw. 11-3 aus der Versorgungseinheit 7 mit Energie versorgt. Sind die Endstufeneinheiten 8 nicht potentialfrei ausgeführt, so sind die Phasen-Versorgungseinheiten 11 auch verzichtbar und die Endstufenansteuerungen 10 können direkt mit der Versorgungseinheit 7 verbunden werden. Von der Steuereinheit 6 erhalten die Endstufenansteuerungen 10 jeweils Steuervorgaben, welche dann in geeignete Steuersignale zur Ansteuerung der Endstufen 9 umgesetzt werden.

Um die Endstufeneinheiten 8 auch bei fehlerhafter Ansteuerung oder Energieversorgung, das heißt bei Ausfall oder Fehlfunktion der Steuereinheit 6 und/oder der Versorgungseinheit 7, betriebsbereit zu halten und Überspannungen auf dem Energieversorgungsnetz sicher zu verhindern, sind in jeder Endstufeneinheit 8 eine Notbetrieb-Steuerung 12 und eine Notbetrieb-Versorgung 13 vorgesehen. Im Fehlerfall werden die Steuervorgaben für die Endstufenansteuerungen 10 und damit die Steuerung der Endstufeneinheiten 8 durch die jeweilige Notbetrieb-Steuerung 12 übernommen. Die Energieversorgung der Endstufeneinheiten 8 erfolgt im Notbetrieb über die Notbetrieb-Versorgungen 13, wobei diese die notwendige Energie aus dem Energieversorgungsnetz 3 erzeugen.

Im dargestellten Ausführungsbeispiel ist für jede Endstufeneinheit 8-1 bis 8-3 jeweils eine eigene Notbetrieb-Steuerung 12-1 bis 12-3 und Notbetrieb-Versorgung 13-1 bis 13-3 vorgesehen. Alternativ dazu können aber auch Notbetrieb-Steuerungen und/oder eine Notbetrieb-Versorgungen vorgesehen sein, die allen oder zumindest mehreren Endstufeneinheiten 8 zugeordnet sind. Entscheidend ist lediglich, dass jeder vorhandenen und genutzten Endstufeneinheit 8 eine Notbetrieb-Steuerung 12 und eine Notbetrieb-Versorgung 13 zugeordnet ist, so dass im Fehlerfall eine von der Steuereinheit 6 und der Versorgungseinheit 7 unabhängige Steuerung bzw. Energieversorgung der Endstufeneinheit 8 sichergestellt ist.

Da während des Notbetriebs, also im Fehlerfall, kein häufiges Schalten der Endstufen 9 nötig ist, ist auch kein großer Umladestrom durch die Notbetrieb-Versorgung 13 bereitzustellen. Diese kann somit für kleine Verlustleistungen ausgelegt werden.

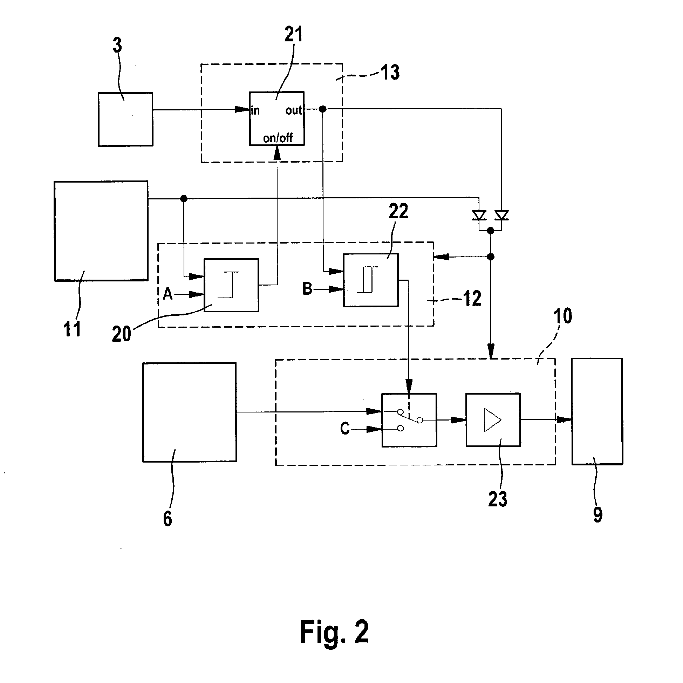

In Fig. 2 ist schematisch eine beispielhafte Schaltung zur Realisierung des erfindungsgemäßen Verfahrens dargestellt. Dabei weist die Notbetrieb-Steuerung 12 eine Vergleichseinheit 20, zum Beispiel in Form eines Schwellwertschalters auf, welche eine von der Phasen-Versorgungseinheit 11 gelieferte Versorgungsspannung mit einem vorgegebenen unteren Schwellwert A der Versorgungsspannung vergleicht. Fällt der von der Phasen-Versorgungseinheit 11 gelieferte Spannungswert unter den Schwellwert A, so wird die Notbetrieb-Versorgung 13, insbesondere ein darin vorgesehener Spannungsregler 21, eingeschaltet. Die Notbetrieb-Versorgung 13 erzeugt daraufhin Energie aus dem Energieversorgungsnetz 3. Die dabei erzeugte Spannung wird durch eine zweite Vergleichseinheit 22, zum Beispiel einen weiteren Schwellwertschalter, innerhalb der Notbetrieb-Steuerung 12 mit einem unteren Schwellwert B der Versorgungsspannung verglichen. Sobald die von der Notbetrieb-Versorgung 13 erzeugte Spannung den unteren Schwellwert B übersteigt, wird ein in der Endstufenansteuerung 10 vorgesehenes Schaltmittel 23 betätigt. Dies hat zur Folge, dass die Endstufe 9 nun nicht mehr über ein von der Steuereinheit 6 vorgegebenes Steuersignal gesteuert wird, sondern über ein Notbetriebs-Steuersignal C, welches zum Beispiel dazu führt, dass der oder die Low-Side-Schaltelemente innerhalb der Endstufe 9 leitend geschaltet werden. Wird diese Steuerung für alle vorhandenen und genutzten Endstufeneinheiten 8 angewendet, wird ein Kurzschlussbetrieb des Wechselrichters 2 realisiert, welcher eine Überspannung in dem Energieversorgungsnetz 3 und damit eine dauerhafte Schädigung der Endstufen 9 sicher verhindert.

Zusätzlich kann auch noch der Stromfluss durch die Endstufen überwacht werden und bei Diagnose eines Überstromes kann das Schalten in einen Kurzschlussbetrieb erst gar nicht zugelassen werden oder ein bereits begonnener Kurzschlussbetrieb abgebrochen werden. Auf diese Weise kann auch noch eine Schädigung der Endstufen durch Überströme verhindert werden.

## Patentansprüche

1. Wechselrichter (2) für eine elektrische Maschine (1) in einem Hybridfahrzeug, mit
- mindestens einer Endstufeneinheit (8) zur Herstellung einer Verbindung zwischen der elektrischen Maschine (1) und einem Energieversorgungsnetz (3),
- einer Steuereinheit (6) zum Steuern der mindestens einen Endstufeneinheit (8),
- **gekennzeichnet durch**
- eine von dem Energieversorgungsnetz (3) unabhängige Versorgungseinheit (7) zur Energieversorgung der Endstufeneinheit/en (8),
- mindestens eine der/den Endstufeneinheit/en (8) zugeordnete Notbetrieb-Steuerung (12) zur Steuerung der Endstufeneinheit/en (8) bei Ausfall oder Fehlfunktion der Steuereinheit (6) und/oder der Versorgungseinheit (7), und
- mindestens eine der/den Endstufeneinheit/en (8) zugeordnete Notbetrieb-Versorgung (13) zur Erzeugung einer Versorgungsenergie für die Endstufeneinheit/en (8) aus dem Energieversorgungsnetz (3) bei Ausfall oder Fehlfunktion der Steuereinheit und/oder der Versorgungseinheit.

2. Wechselrichter (2) nach Anspruch 1, wobei die mindestens eine Notbetrieb-Steuerung (12) Betriebsparameter innerhalb des Wechselrichters (2) überwacht und einen Ausfall oder eine Fehlfunktion der Steuereinheit (6) und/oder der Versorgungseinheit (7) diagnostiziert, wenn mindestens einer der Betriebsparameter unterhalb eines vorgegebenen unteren Schwellwertes oder oberhalb eines vorgegeben oberen Schwellwertes liegt.

3. Wechselrichter (2) nach einem der Ansprüche 1 oder 2, wobei die mindestens eine Notbetrieb-Versorgung (13) ein- und abschaltbar ausgeführt ist.

4. Verfahren zum Betreiben eines Wechselrichters (2) für eine elektrische Maschine (1) in einem Hybridfahrzeug, wobei der Wechselrichter (2) mindestens eine Endstufeneinheit (8) zur Herstellung einer Verbindung zwischen der elektrischen Maschine (1) und einem Energieversorgungsnetz (3) aufweist, **dadurch gekennzeichnet, dass** in dem Verfahren im Normalbetrieb die Endstufeneinheit/en (8) über eine von dem Energieversorgungsnetz (3) unabhängige Versorgungseinheit (7) mit Energie versorgt und über eine Steuereinheit (6) gesteuert wird/werden und bei Ausfall oder Fehlfunktion der Steuereinheit (6) und/oder der Versorgungseinheit (7) durch mindestens eine Notbetrieb-Versorgung (13) Energie zur Energieversorgung der Endstufeneinheit/en (8) aus dem Energieversorgungsnetz (3) erzeugt wird und die Endstufeneinheit/en (8) durch mindestens eine Notbetrieb-Steuerung (12) gesteuert wird/werden.

5. Verfahren nach Anspruch 4, wobei ein Ausfall oder eine Fehlfunktion der Steuereinheit (6) und/oder der Versorgungseinheit (7) durch Auswertung von Betriebsparametern innerhalb des Wechselrichters (2) diagnostiziert wird.

6. Verfahren nach Anspruch 5, wobei ein Ausfall oder eine Fehlfunktion der Steuereinheit (6) und/oder der Versorgungseinheit (7) diagnostiziert wird, wenn mindestens einer der Betriebsparameter unterhalb eines vorgegebenen unteren Schwellwertes oder oberhalb eines vorgegeben oberen Schwellwertes liegt.

7. Verfahren nach einem der Ansprüche 4 bis 6, wobei die mindestens eine Notbetrieb-Versorgung (13) nach Diagnose eines Ausfall oder einer Fehlfunktion der Steuereinheit (6) und/oder der Versorgungseinheit (7) eingeschaltet wird.

8. Verfahren nach Anspruch 7, wobei die mindestens eine Notbetrieb-Versorgung (13) wieder abgeschaltet wird, sobald kein Ausfall oder Fehlfunktion der Steuereinheit (6) und/oder der Versorgungseinheit (7) mehr diagnostiziert wird.

9. Verfahren nach einem der Ansprüche 4 bis 8, wobei die Notbetrieb-Steuerung (12) die jeweilige Endstufeneinheit (8) derart steuert, dass eine Überspannung im Energieversorgungsnetz (3) verhindert wird.

10. Verfahren nach Anspruch 9, wobei die Notbetrieb-Steuerung (12) die jeweilige Endstufeneinheit (8) derart steuert, dass Schaltelemente innerhalb der Endstufeneinheit (8) in einen Kurzschlussbetrieb geschaltet werden.

11. Verfahren nach Anspruch 10, wobei die Notbetrieb-Steuerung (12) die jeweilige Endstufeneinheit (8) derart steuert, dass ein Überstrom in der Endstufe verhindert wird.

12. Verfahren nach Anspruch 11, wobei bei Diagnose eines Überstromes nicht das Schalten in den Kurzschlussbetrieb verhindert wird oder ein Kurzschlussbetrieb abgebrochen wird.

## Claims

1. Inverter (2) for an electric machine (1) in a hybrid vehicle, comprising
- at least one output stage unit (8) for producing a connection between the electric machine (1) and an energy supply grid (3),
- a control unit (6) for controlling the at least one output stage unit (8),
- **characterized by**
- a supply unit (7), which is independent of the energy supply grid (3), for supplying energy to the output stage unit(s) (8),
- at least one emergency operation controller (12) assigned to the output stage unit(s) (8) for controlling the output stage unit(s) (8) in the event of failure or malfunction of the control unit (6) and/or of the supply unit (7), and
- at least one emergency operation supply (13) assigned to the output stage unit(s) (8) for generating a supply energy for the output stage unit(s) (8) from the energy supply grid (3) in event of failure or malfunction of the control unit and/or of the supply unit.

2. Inverter (2) according to Claim 1, wherein the at least one emergency operation controller (12) monitors operational parameters within the inverter (2) and diagnoses a failure or a malfunction of the control unit (6) and/or of the supply unit (7) when at least one of the operational parameters is below a predetermined lower threshold value or above a predetermined upper threshold value.

3. Inverter (2) according to either of Claims 1 and 2, wherein the at least one emergency operation supply (13) is configured so as to be capable of being switched on and off.

4. Method for operating an inverter (2) for an electric machine (1) in a hybrid vehicle, wherein the inverter (2) has at least one output stage unit (8) for producing a connection between the electric machine (1) and an energy supply grid (3), **characterized in that**, in the method, during normal operation energy is supplied to the output stage unit(s) (8) via a supply unit (7) which is independent of the energy supply grid (3), and said output stage unit(s) (8) is/are controlled via a control unit (6) and, in the event of failure or malfunction of the control unit (6) and/or of the supply unit (7), energy is generated by at least one emergency operation supply (13) for supplying energy to the output stage unit(s) (8) from the energy supply grid (3), and the output stage unit(s) (8) is/are controlled by at least one emergency operation controller (12).

5. Method according to Claim 4, wherein a failure or a malfunction of the control unit (6) and/or of the supply unit (7) is diagnosed by evaluation of operational parameters within the inverter (2).

6. Method according to Claim 5, wherein a failure or malfunction of the control unit (6) and/or of the supply unit (7) is diagnosed when at least one of the operational parameters is below a predetermined lower threshold value or above a predetermined upper threshold value.

7. Method according to one Claims 4 to 6, wherein the at least one emergency operation supply (13) is switched on after diagnosis of a failure or a malfunction of the control unit (6) and/or of the supply unit (7).

8. Method according to Claim 7, wherein the at least one emergency operation supply (13) is switched off again as soon as failure or malfunction of the control unit (6) and/or of the supply unit (7) is no longer diagnosed.

9. Method according to one of Claims 4 to 8, wherein the emergency operation controller (12) controls the respective output stage unit (8) in such a way that an overvoltage in the energy supply grid (3) is prevented.

10. Method according to Claim 9, wherein the emergency operation controller (12) controls the respective output stage unit (8) in such a way that switching elements within the output stage unit (8) are switched to a short-circuit operating mode.

11. Method according to Claim 10, wherein the emergency operation controller (12) controls the respective output stage unit (8) in such a way that an overcurrent in the output stage is prevented.

12. Method according to Claim 11, wherein, in the event of diagnosis of an overcurrent, switching to the short-circuit operating mode is prevented or a short-circuit operating mode is terminated.

## Revendications

1. Onduleur (2) pour moteur électrique (1) de véhicule hybride, l'onduleur présentant :
au moins une unité (8) d'étage final qui établit une liaison entre le moteur électrique (1) et un réseau (3) d'alimentation en énergie,
une unité de commande (6) qui commande la ou les unités (8) d'étage final,
**caractérisé par**
une unité d'alimentation (7) indépendante du réseau (3) d'alimentation en énergie et alimentant en énergie la ou les unités (8) d'étage final,
au moins une commande de secours (12) associée à la ou aux unités (8) d'étage final et commandant la ou les unités (8) d'étage final en cas de défaillance ou de fonctionnement défectueux de l'unité de commande (6) et/ou de l'unité d'alimentation (7) et
au moins une alimentation de secours (13) associée à la ou aux unités (8) d'étage final pour délivrer l'énergie d'alimentation à la ou aux unités (8) d'étage final à partir du réseau (3) d'alimentation en énergie en cas de défaillance ou de fonctionnement défectueux de l'unité de commande et/ou de l'unité d'alimentation.

2. Onduleur (2) selon la revendication 1, dans lequel la ou les commandes de secours (12) surveillent des paramètres de fonctionnement à l'intérieur de l'onduleur (12) et diagnostiquent une défaillance ou un fonctionnement défectueux de l'unité de commande (6) et/ou de l'unité d'alimentation (7) si au moins l'un des paramètres de fonctionnement est situé en dessous d'une valeur inférieure de seuil prédéterminée ou au-dessus d'une valeur de seuil supérieure prédéterminée.

3. Onduleur (2) selon l'une des revendications 1 ou 2, dans lequel la ou les alimentations de secours (13) peuvent être branchées et débranchées.

4. Procédé de conduite d'un onduleur (2) pour moteur électrique (1) de véhicule hybride, l'onduleur (2) présentant au moins une unité (8) d'étage final qui établit une liaison entre le moteur électrique (1) et un réseau (3) d'alimentation en énergie,
**caractérisé en ce que**
dans le procédé, en fonctionnement normal, la ou les unités (8) d'étage final sont alimentées en énergie par l'intermédiaire d'une unité d'alimentation (7) indépendante du réseau (3) d'alimentation en énergie et sont commandées par une unité de commande (6),
**en ce qu'**en cas de défaillance ou de fonctionnement défectueux de l'unité de commande (6) et/ou de l'unité d'alimentation (7), de l'énergie est produite à partir du réseau (3) d'alimentation en énergie par au moins une alimentation de secours (13) pour alimenter en énergie la ou les unités (8) d'étage final et
**en ce que** la ou les unités (8) d'étage final sont commandées par au moins une commande de secours (12).

5. Procédé selon la revendication 4, dans lequel une défaillance ou un fonctionnement défectueux de l'unité de commande (6) et/ou de l'unité d'alimentation (7) sont diagnostiqués par évaluation de paramètres de fonctionnement à l'intérieur de l'onduleur (2).

6. Procédé selon la revendication 5, dans lequel une défaillance ou un fonctionnement défectueux de l'unité de commande (6) et/ou de l'unité d'alimentation (7) sont diagnostiqués si au moins l'un des paramètres de fonctionnement est situé en dessous d'une valeur de seuil inférieure prédéterminée ou au-dessus d'une valeur de seuil supérieure prédéterminée.

7. Procédé selon l'une des revendications 4 à 6, dans lequel après diagnostic d'une défaillance ou d'un fonctionnement défectueux de l'unité de commande et/ou de l'unité d'alimentation (7), la ou les alimentations de secours (13) sont branchées.

8. Procédé selon la revendication 7, dans lequel la ou les alimentations de secours (13) sont de nouveau débranchées dès qu'une défaillance ou qu'un fonctionnement défectueux de l'unité de commande (6) et/ou de l'unité d'alimentation (7) ne sont plus diagnostiqués.

9. Procédé selon l'une des revendications 4 à 8, dans lequel la commande de secours (12) commande l'unité (8) d'étage final concerné de manière à empêcher l'apparition de surtensions dans le réseau (3) d'alimentation en énergie.

10. Procédé selon la revendication 9, dans lequel la commande de secours (12) commande l'unité (8) d'étage final concerné de manière à brancher en court-circuit des éléments de commutation situés à l'intérieur de l'unité (8) d'étage final.

11. Procédé selon la revendication 10, dans lequel la commande de secours (12) commande l'unité (8) d'étage final concerné de manière à empêcher un sur-courant dans l'étage final.

12. Procédé selon la revendication 11, dans lequel le diagnostic d'un sur-courant empêche le branchement en court-circuit ou interrompt un fonctionnement en court-circuit.
